# EUROPEAN PATENT APPLICATION

(11) **EP 1 944 834 A2**
(43) Date of publication of application: **16.07.2008**
(21) Application number: 07123296.1
(22) Date of filing: 14.12.2007
(51) Int. Cl.: H01R 12/34

(54) **Compliant pin**

(30) Priority: 10.01.2007 US 651793
(71) Applicant: Delphi Technologies, Inc., Troy, Michigan 48007 (US)
(72) Inventor: Tang, Liang, Santa Clara, CA 95051 (US)
(74) Representative: Denton, Michael John

(57) **Abstract**

A pin (100) for insertion into a hole (200) includes a compliant zone (Z₂) having a first flex-beam (120) and a second flex-beam (122), the first flex-beam (120) being a predetermined distance (210a) from the second flex-beam (122). The pin further includes a lead-in zone (Z₁) extending from the compliant zone (Z₂), wherein a width of the lead-in zone (Z₁) narrows to a tip (112).

## Description

### TECHNICAL FIELD

The present embodiments relate to an electrical contact, and in particular, to a press fit electrical contact for use with plated through holes.

### BACKGROUND INFORMATION

Compliant pins typically include a press-fit portion attached to a lead frame for solderless connection to a printed circuit board (PCB). The press-fit portion is for pressing electrical contact with a plated-through-hole (PTH) of a printed circuit board. By being plated through, the PTH is lined with copper, plated with nickel, etc., and is connected to surface traces on the printed circuit board to make additional electrical connections. Moreover, a press-fit portion may be a solid design or may include an eye, which allows for compression of the press-fit portion. The eye-of-needle press-fit portion includes a single curve defining the longitudinal shape that is pressed into the PTH. When a press-fit portion is driven into the PTH, the press-fit portion and the plating of the PTH deform. The press-fit portion is typically retained in the PTH by pressure and friction. In this way, the press-fit portion only contacts the plated wall of the PTH at the four corners of the pin. Thus, there is a limited contact area and the force holding the pin in the PTH is concentrated on the four corners of the pin, which leads to damage of the pin and the PTH. Given the highly concentrated force, the frictional force holding the pin in the PTH may be unreliable for retaining the pin in the PTH.

Alternatively, thermal cycling and vibration may shift the pin in the PTH reducing electrical performance. In many cases, the current carrying capability of the pin and the PTH are reduced due to the insertion damage. Additionally, many compliant pins use phosphor-bronze as a base material whose electrical conductivity is only about eighteen percent (18%).

The embodiments described hereinafter were developed in light of these and other drawbacks associated with press-fitting electrical contacts through plated through-holes.

### SUMMARY OF THE INVENTION

A pin for insertion into a hole includes a compliant portion including a pair of outwardly biased beam members having a beam profile. The pin further includes a lead-in portion connected to the compliant portion, wherein the lead-in portion has a lead-in profile and wherein a width of the lead-in profile continuously narrows from the compliant portion to a tip. The lead-in profile is different from the beam profile.

Another embodiment of a pin is provided that includes a lead-in segment having a lead-in outer edge, and a compliant segment connected to said lead-in segment, wherein the compliant segment includes a first beam member and a second beam member, the first beam member and the second beam member each having a beam outer edge. The lead-in outer edge comprises a first curve and the beam outer edge comprises a second curve, and wherein the lead-in outer edge continuously narrows from the compliant segment to a tip.

In yet another embodiment, a pin for insertion into a hole is provided that includes a compliant zone having a first flex-beam and a second flex-beam, wherein an inner surface of the first flex-beam is a predetermined distance from an inner surface of the second flex-beam. The pin further includes a lead-in zone extending from the compliant zone, wherein a width of the lead-in zone narrows to a tip.

### BRIEF DESCRIPTION OF THE DRAWINGS

FIG. 1A is a side perspective view of an exemplary compliant pin.

FIG. 1B is a cross sectional view of the compliant pin of FIG. 1A.

FIG. 2 is a top cross-sectional view of the compliant pin of FIG. 1 when in a relaxed state.

FIG. 3A is a side cross-sectional view of the compliant pin of FIG. 1 when the compliant pin is initially placed in a plated-through-hole.

FIG. 3B is a top cross-sectional view of the compliant pin of FIG. 1, taken along section line 3B as shown in FIG. 3A, when the compliant pin is initially pressed into a plated-through-hole.

FIG. 4A is a top cross-sectional view of the compliant pin of FIG. 1, taken along section line 4A as shown in FIG. 4B, when the compliant pin is fully pressed into a plated-through-hole.

FIG. 4B is a side cross-sectional view of the compliant pin of FIG. 1, taken along section line 4B as shown in FIG. 4A, when the compliant pin is fully pressed into a plated-through-hole.

### DESCRIPTION OF THE PREFERRED EMBODIMENTS

A pin is disclosed for insertion into a plated-through-hole (PTH) of a printed circuit board. In one embodiment, the pin is configured as a power pin, however, one of ordinary skill in the art understands that the pin may be configured for any number of purposes, including but not limited to, a signal pin. The pin includes a dual flex-beam design having an eye-of-needle detail that allows the flex-beams to move towards one another when the pin is inserted into the PTH. The pin also includes a 3-zone design, including a lead-in zone, a compliant zone, and a shoulder zone. The lead-in zone pilots the pin into the PTH, where the edge profile of the lead-in zone is substantially linear. The compliant zone has a substantially radial edge profile and provides electrical and mechanical connection to the PTH. The radial edge profile of the compliant zone provides that the engagement force (or insertion force) is minimized as well as minimizing the potential for damage to the plating of the PTH when the pin is inserted into and contacts the PTH. Moreover, the radial profile of the compliant zone provides that the majority of the force applied to the PTH is further inward from the outer rim of the PTH (e.g., at the center of the printed circuit board). The starting point of the compliant zone (which is at the transition of the lead-in zone to the compliant zone) is, at a maximum, equal to the finished PTH diameter. Thus, the start of flexing deformation of the beams is controlled as being in the compliant zone. The beginning of the eye (at the compliant portion) is not higher than the beginning of the compliant portion and provides that the beams always have space between them to flex inwardly to avoid damage.

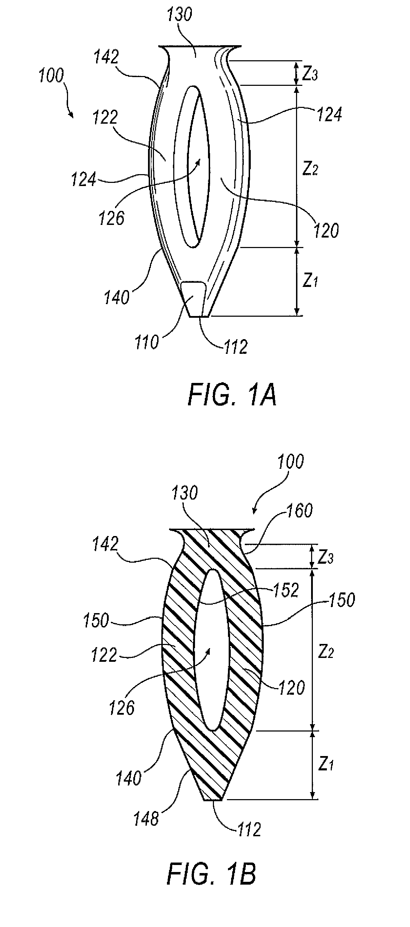

FIG. 1A is a side perspective view of an exemplary compliant pin 100. Compliant pin 100 comprises a lead-in portion Z₁, a compliant portion Z₂, and a shoulder portion Z₃. Lead-in portion Z₁ is configured to be first inserted into the PTH of a printed circuit board. Compliant portion Z₂ includes a contacting edge 124 configured to interfere with the walls of the PTH and allow for electrical current flow between compliant portion Z₂ and the PTH. Shoulder portion Z₃ is configured to connect compliant portion Z₂ with a shoulder portion 130 of compliant pin 100 to carry electrical current, for example, to a connector, wire, or circuit board.

Lead-in portion Z₁ includes a lateral facet 110 that is mirrored on the back side of lead-in portion Z₁ (not shown) that is near a tip 112. Lead-in portion Z₁ generally serves to pilot compliant pin 100 to the PTH. A first transition point 140 distinguishes the outer profile of lead-in portion Z₁ from compliant portion Z₂. Compliant portion Z₂ includes a first flex beam 120 and a second flex beam 122 that are separated by an elongated opening 126. First flex beam 120 and second flex beam 122, comprising compliant portion Z₂, connect the lead-in portion Z₁ with shoulder portion Z₃.

A second transition point 142 distinguishes the outer profile of compliant portion Z₂ from shoulder portion Z₃. Shoulder portion Z₃ may comprise a straight box-like portion that extends away from compliant portion Z₂, but may be configured for any connection to connectors, wires, or other printed circuit boards. Moreover, shoulder portion Z₃ may be configured, for example, as a crimp terminal, a female terminal, or to connect to another compliant pin 100.

FIG. 1B is a cross sectional view of compliant pin 100 of FIG. 1A. In an embodiment, lead-in portion Z₁ includes a lead-in curve 148 as being configured as a straight curve, shown as the edge profile in FIG. 1B. Lead-in curve 148 extends from a first transition point 140 to tip 112 and continuously narrows in width from first transition point 140 to tip 112. At compliant portion Z₂, flex-beam curve 150 is formed of a single continuous curve, optimized to avoid damage to an inner wall of the PTH when inserted.

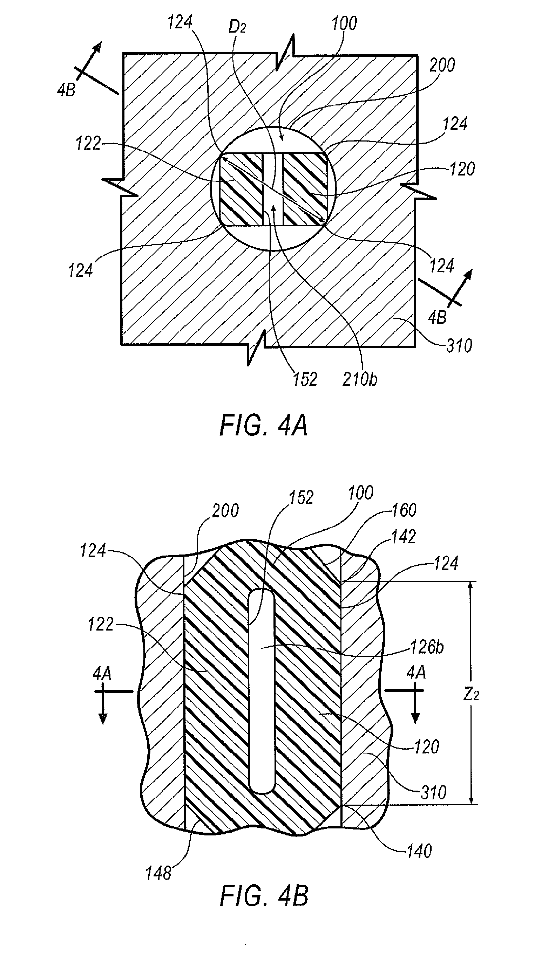

Beams 120, 122 are configured for shape, thickness, and material, to avoid damaging the inner PTH wall of the PTH (discussed below in detail with respect to FIG. 4B). Elongated opening 126 is configured to allow for compression of compliant portion Z₂ and, an in particular, the inward flexing of beams 120, 122 to avoid damage to the PTH plating. When compliant pin 100 is fully inserted in the PTH, beams 120, 122 flex inward but are not in touching contact with one another. In other words, beams 120, 122 are not forced into contact with one another at any point when compliant pin 100 is inserted in the PTH. Moreover, elongated opening 126 begins at the beginning of compliant portion Z₂ (at first transition point 140) such that during insertion of compliant pin 100 into the PTH, beams 120, 122 always have a space to flex inwardly and avoid damaging the plating of the PTH.

Inner curve 152 is shaped similarly to, but not necessarily identically to, flex-beam curve 150 and provides the shape for elongated opening 126. Inner curve 152 may also be shaped to provide thicker or thinner portions of beams 120, 122 depending upon the insertion force, retention force, and acceptable flexing of beams 120, 122 to adjust for the susceptibility of the PTH plating to damage. Thus, the shape or curve of inner curve 152 may be determined by design guidelines depending upon the implementation requirements.

Flex-beam curve 150 is defined as the outer profile, or edge, of compliant pin 100 along beams 120, 122. The edge defining flex-beam curve 150 is shown on the outer edge of beams 120, 122 and is defined between first transition point 140 and second transition point 142, corresponding with compliant portion Z₂. Shoulder curve 160 is defined as the profile, or edge, of shoulder portion 130. In one embodiment, shoulder curve 160 includes a straight portion that extends from second transition point 142 and then may become curved, or otherwise connect with the rest of the pin from shoulder portion 130.

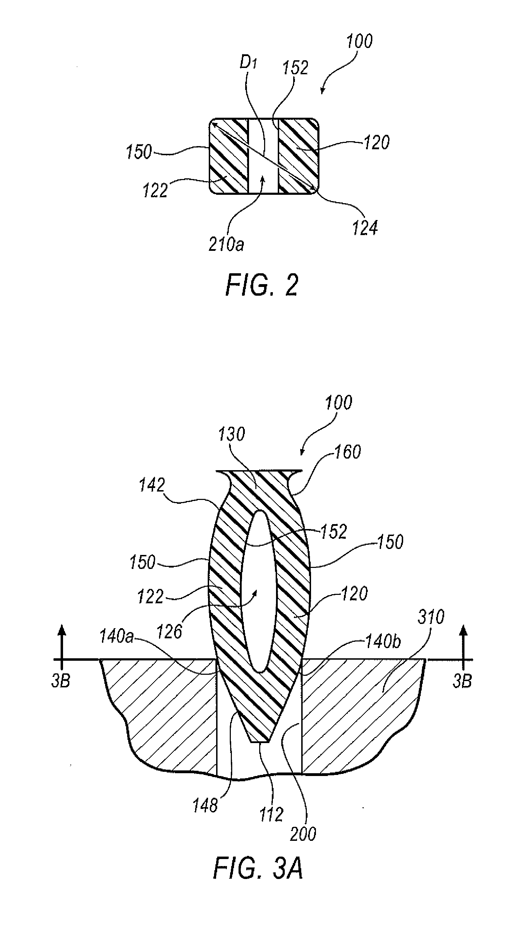

FIG. 2 is a top cross-sectional view of compliant pin 100 of FIG. 1 when in a relaxed state. A relaxed outer dimension D₁ is measured from the outside of contacting edge 124 to an opposite contacting edge 124 (e.g., diagonal). Moreover, when compliant pin 100 is in a relaxed state (e.g., beams 120, 122 are not compressed), relaxed outer dimension D₁ is larger than the diameter of the PTH (discussed in detail with respect to FIG. 4A). As discussed above, contacting edge 124 is rounded over to avoid damaging the PTH, or more specifically, the plating of the hole. Thus, because relaxed outer dimension D₁ is larger than the diameter of the PTH, there is necessarily an interference of compliant portion Z₂ with the PTH when compliant pin 100 is pressed into the PTH. A relaxed gap 210a is defined by the space between inner curves 152 of beams 120, 122 that are spaced apart in a relaxed state.

FIG. 3A is a side cross-sectional view of compliant pin 100 of FIG. 1 when compliant pin 100 is initially pressed into a plated-through-hole 200. Tip 112 is first positioned at the opening of hole 200 and compliant pin 100 is pressed therein. In an embodiment, compliant pin 100 includes a lead-in portion Z₁ (shown in FIG. 1B) that includes a lead-in curve 148. First transition point 140 is where straight lead-in curve 148 transitions to flex-beam curve 150. The straight feature of lead-in curve 148 allows for fast alignment of compliant pin 100 with hole 200, as well as reducing the insertion force up to that point.

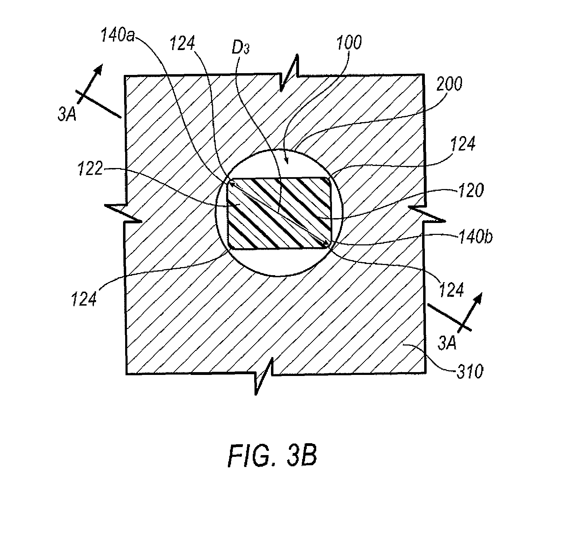

FIG. 3B is a top cross-sectional view of the compliant pin of FIG. 1, taken along section line 3B as shown in FIG. 3A, when the compliant pin is initially pressed into hole 200. A transition dimension D₃ of compliant pin 100 taken at the widest point between first transition points 140a, 140b (also shown in FIG. 3A) is, in an embodiment, less than the diameter of hole 200. In other embodiments, transition dimension D₃ may be the same as but not bigger than the diameter of hole 200.

As shown in FIG. 3B, transition dimension D₃ is equal to the diameter of hole 200 such that when compliant pin 100 is further pressed within hole 200, beams 120, 122 (see FIG. 3A) interferes with the inner wall of hole 200. The insertion force is reduced, and damage minimized to the plating of hole 200 because there is a smooth transition at first transition points 140a, 140b from lead-in portion Z₁ (shown in FIG. 1B) to compliant portion Z₂. Moreover, transition dimension D₃ is, at most, equal to the diameter of hole 200, such that damage is minimized or eliminated during insertion of lead-in portion Z₁ (shown in FIG. 1B) to hole 200. Because transition dimension D₃ is maximally equal to the diameter of hole 200, there is no deforming interference from the insertion of lead-in portion Z₁ to hole 200.

In one embodiment, the starting point of interference of compliant pin 100 with hole 200 begins, at first transition point 140. The beginning of compliant portion Z₂ generally controls when compliant pin 100 comes into interference contact with hole 200. Transition dimension D₃ may be configured to be less than the diameter of hole 200, in which case compliant pin 100 will not begin interfering with hole 200 until after compliant portion Z₂ begins. In an embodiment, transition dimension D₃ is equal to the diameter of hole 200 and interference begins at the beginning of compliant portion Z₂. In another embodiment, transition dimension D₃ is smaller than or equal to the finished plated hole diameter of hole 200. Otherwise, damage to compliant pin 100 and/or the plating of hole 200 may result. When configured as described in the embodiment herein, damage is avoided because the start of compliant portion Z₂ is configured such that bending (e.g., flexing) of beams 120, 122 begins precisely at the start of, or just after the start of, compliant portion Z₂. Otherwise, damage may occur to hole 200 during insertion of lead-in portion Z₁.

FIG. 4A is a top cross-sectional view of compliant pin 100 of FIG. 1 when fully pressed into hole 200, taken along section line 4A as shown in FIG. 4B. A circuit board 310 includes hole 200. Circuit board 310 may be a typical circuit board made of, for example, FR-4, FR-2, or CEM-1. However, circuit board 310 may also include any structure or substrate having a hole 200, wherein hole 200 includes an inner periphery configured for an electrical connection.

When compliant pin 100 is pressed into hole 200, beams 120, 122 are pressed together by the wall of hole 200. When compliant pin 100 is fully pressed into hole 200, a compressed outer dimension D₂ is the same dimension as the diameter of hole 200. Compressed outer dimension D₂ is measured from one contacting edge 124 to an opposite contacting edge 124 (e.g., diagonal) as shown in FIG. 4A. A compressed gap 210b is smaller than relaxed gap 210a (shown in FIG. 2) because beams 120, 122 are pressed closer together. In both cases, relaxed gap 210a and compressed gap 210b are greater than zero because beams 120, 122 should be separated by a predetermined distance even when compressed after compliant pin 100 is installed into hole 200. In an embodiment, beams 120, 122 and gap 210 are configured to avoid beams 120, 122 from being forced together such that beams 120, 122 do not deform when inserted into hole 200. This is because a lack of deformation of beams 120, 122 avoids damaging the plating of hole 200.

At each outer corner of beams 120, 122, contacting edges 124 contact the inner diameter of hole 200 to provide electrical contact. Moreover, because of the shape of beams 120, 122 and the flexibility provided by gap 210b, contacting edges 124 are of a lower pressure contact upon insertion of compliant pin 100 into hole 200 such that the plating of hole 200 is not damaged when compliant pin 100 is inserted. In an embodiment, contacting edge 124 is a rounded corner such that contacting edge 124 does not "cut" into the plating of hole 200.

FIG. 4B is a side cross-sectional view of compliant pin 100 of FIG. 1 when fully pressed into hole 200, taken along section line 4B as shown in FIG. 4A. Beams 120, 122 are pressed toward each other when compliant pin 100 is pressed into hole 200. Thus, elongated opening 126b is smaller in width than when compliant pin 100 is uncompressed (see elongated opening 126a of FIG. 2). At any part of the insertion process, elongated opening 126b is not completely closed such that beams 120, 122 contact each other. This is because the thickness of beams 120, 122, as defined by the thickness between outer flex-beam curve 150 and the inner curve 152, are configured such that the insertion of compliant pin 100 into hole 200 (of a known diameter) will not completely collapse elongated opening 126b. Thus, beams 120, 122 always have space provided by elongated opening 126b to flex inwardly. In this way, pin 100 is configured to control the insertion force and retention force by the shape and thickness of beams 120, 122, and elongated opening 126, as well as the material of pin 100. Additionally, these parameters also control the maximum force applied by pin 100 to the plating of hole 200 in order to control damage to the plating of hole 200.

When compliant pin 100 is fully inserted into hole 200, compliant portion Z₂ is pressed flush along the inner surface of hole 200. In contrast to flex-beam curve 150 of compliant portion Z₂ (shown in detail in FIG. 1B), beams 120, 122 flex inwardly toward each other when compliant pin 100 is pressed into hole 200. Contacting edges 124 interface mechanically with hole 200 to provide an electrical connection along the periphery of beams 120, 122 between first transition point 140 and second transition point 142. There is no contact of compliant pin 100 with hole 200 beyond first transition point 140 (at lead-in portion Z₁, shown in FIG. 1A) or beyond second transition point 142 (at shoulder portion Z₃, shown in FIG. 1A). Thus, compliant pin 100 mechanically interferes with hole 200 at compliant portion Z₂.

The material for compliant pin 100 may be, for example, Copper Development Association alloy number four hundred twenty five ("CDA 425"), which possesses superior current carrying capacity as compared to a phosphor bronze alloy. CDA 425 is typically an "ambronze" that comprises approximately 84% copper, approximately 2% tin, and approximately 14% zinc. Moreover, CDA 425 guarantees automotive high current capacity requirements when used as the base material. However, other materials may also be used, including a phosphor bronze alloy, depending upon the current carrying requirements of pin 100. Where higher currents are required, CDA 425 provides for increased current carrying capability over a phosphor bronze alloy.

Increased current carrying capability is also provided through reduced damage to compliant pin 100 and hole 200 during insertion and holding. Because lead-in portion Z₁ is substantially linear, the insertion of compliant pin 100 into hole 200 does not cause substantial deformation, cutting, or other damage to the plating of hole 200 or compliant pin 100. Thus, the current carrying capability of the plating of hole 200 and contacting edges 124 of compliant pin 100 are preserved for high-pressure uninterrupted connection. Thus, a higher current is realized through reduced damage to the plating of hole 200 and to compliant pin 100. Additionally, the substantially linear profile of lead-in portion Z₁ provides for a reduced insertion force of compliant pin 100.

The substantially linear lead-in portion Z₁ transitions to the curved compliant portion Z₂. The curved profile provides that beams 120, 122 will interfere with the plating of hole 200 to retain pin 100 and beams 120, 122 will be pressed toward each other without substantially deforming compliant pin 100.
The curvature, from a radius or radii, allows for greatest interference at or near the center of compliant portion Z₂. Moreover, the greatest interference of compliant pin 100 with the plating of hole 200 is within hole 200 rather than on the outer edge (which may be more susceptible to insertion damage). The configuration of beams 120, 122, as well as the materials used to construct compliant pin 100, provide a high retaining force, which is important for current conduction and for high-vibration environment.

In the design and configuration of compliant pin 100, the design of compliant portion Z₂ (including elongated opening 126, flex-beam curve 150, inner curve 152, the thickness of beams 120, 122, and the material) may be performed using finite element analysis (FEA). Both the transverse and longitudinal variables of compliant portion Z₂ may be optimized simultaneously to reduce damage to hole 200 and compliant pin 100.

The present invention has been particularly shown and described with reference to the foregoing examples, which are merely illustrative of the best modes for carrying out the invention. It should be understood by those skilled in the art that various alternatives to the examples of the invention described herein may be employed in practicing the invention without departing from the spirit and scope of the invention as defined in the following claims. The examples should be understood to include all novel and non-obvious combinations of elements described herein, and claims may be presented in this or a later application to any novel and non-obvious combination of these elements. Moreover, the foregoing embodiments are illustrative, and no single feature or element is essential to all possible combinations that may be claimed in this or a later application.

It is to be understood that the above description is intended to be illustrative and not restrictive. Many alternative approaches or applications other than the examples provided would be apparent to those of skill in the art upon reading the above description. The scope of the invention should be determined, not with reference to the above description, but should instead be determined with reference to the appended claims, along with the full scope of equivalents to which such claims are entitled. It is anticipated and intended that future developments will occur in the arts discussed herein, and that the disclosed systems and methods will be incorporated into such future examples. In sum, it should be understood that the invention is capable of modification and variation and is limited only by the following claims.

The present embodiments have been particularly shown and described, which are merely illustrative of the best modes. It should be understood by those skilled in the art that various alternatives to the embodiments described herein may be employed in practicing the claims without departing from the spirit and scope as defined in the following claims. It is intended that the following claims define the scope of the invention and that the method and apparatus within the scope of these claims and their equivalents be covered thereby. This description should be understood to include all novel and non-obvious combinations of elements described herein, and claims may be presented in this or a later application to any novel and non-obvious combination of these elements. Moreover, the foregoing embodiments are illustrative, and no single feature or element is essential to all possible combinations that may be claimed in this or a later application.

All terms used in the claims are intended to be given their broadest reasonable constructions and their ordinary meanings as understood by those skilled in the art unless an explicit indication to the contrary is made herein. In particular, use of the singular articles such as "a," "the," "said," etc. should be read to recite one or more of the indicated elements unless a claim recites an explicit limitation to the contrary.

## Claims

1. A pin for insertion into a hole, the pin comprising:
a compliant portion including a pair of outwardly biased beam members having a beam profile, and
a lead-in portion connected to said compliant portion, said lead-in portion having a lead-in profile, wherein a width of said lead-in profile continuously narrows from said compliant portion to a tip;
wherein said lead-in profile is different from said beam profile.

2. The pin of claim 1, wherein said lead-in profile is substantially straight.

3. The pin of claim 1, wherein said lead-in profile is configured to minimize engagement force of said pin when inserted into said hole.

4. The pin of claim 1, wherein said beam profile is curved.

5. The pin of claim 1, wherein said lead-in profile has a first curvature and said beam profile has a second curvature.

6. The pin of claim 1, wherein a starting distance is defined by the farthest outward surfaces of said pair of outwardly biased beam members at the transition of said lead-in profile to said beam profile, and wherein said starting distance is at most substantially equal to the inside diameter of the hole.

7. The pin of claim 1, said tip further comprising at least one facet, whereby said facet assists in centering said tip with said hole upon insertion.

8. The pin of claim 1, wherein further comprising a shoulder segment having a shoulder profile, said shoulder profile being different than either of said lead-in profile and said beam profile.

9. The pin of claim 1, wherein said beam members are separated by an elongated opening.

10. A pin for insertion into a hole, the pin comprising:
a lead-in segment having a lead-in outer edge;
a compliant segment connected to said lead-in segment, said compliant segment including a first beam member and a second beam member, said first beam member and said second beam member each having a beam outer edge;
wherein said lead-in outer edge comprises a first curve and said beam outer edge comprises a second curve, and wherein said lead-in outer edge continuously narrows from said compliant segment to a tip.

11. The pin of claim 10, wherein said first beam member and said second beam member are separated by a predetermined distance.

12. The pin of claim 10, wherein a maximum distance is defined by the farthest outward edges of said first beam member and said second beam member at the transition of said lead-in outer edge to said beam outer edge, and wherein said maximum distance is at most substantially equal to the inner diameter of the hole.

13. The pin of claim 10, wherein said lead-in edge extends substantially to said tip.

14. The pin of claim 10, wherein said tip further comprising at least one facet, whereby said facet assists in centering said tip with said hole upon insertion.

15. The pin of claim 10, wherein said first beam member and said second beam member are separated by an elongated opening.

16. A pin for insertion into a hole, the pin comprising:
a compliant zone having a first flex-beam and a second flex-beam, wherein an inner surface of said first flex-beam is a predetermined distance from an inner surface of said second flex-beam;
a lead-in zone extending from said compliant zone, wherein a width of said lead-in zone narrows to a tip.

17. The pin of claim 16, wherein said lead-in zone extends from said compliant zone at a transition point.

18. The pin of claim 17, wherein said transition point distinguishes an outer profile of said lead-in zone from an outer profile of said compliant zone.

19. The pin of claim 17, wherein a width at said transition point is no greater than an inner diameter of the hole.

20. The pin of claim 16, wherein a minimum predetermined distance is maintained between said first and said second flex-beams when said pin is inserted into the hole.
